Europäisches Patentamt

European Patent Office

Office européen des brevets

(11) Publication number: **0 243 074 B1**

# EUROPEAN PATENT SPECIFICATION

(45) Date of publication of patent specification: **10.03.93** (51) Int. Cl.5: **H01L 21/205, C23C 16/24**

(21) Application number: **87303270.0**

(22) Date of filing: **14.04.87**

(54) **Process for forming deposited film.**

(30) Priority: **14.04.86 JP 85509/86**

(43) Date of publication of application:
**28.10.87 Bulletin 87/44**

(45) Publication of the grant of the patent:
**10.03.93 Bulletin 93/10**

(84) Designated Contracting States:
**AT BE CH DE ES FR GB GR IT LI LU NL SE**

(56) References cited:
**EP-A- 0 241 311**     **EP-A- 0 241 317**
**EP-A- 0 242 182**     **EP-A- 0 242 207**
**DE-A- 3 225 398**     **DE-A- 3 429 899**
**US-A- 4 522 662**     **US-A- 4 578 142**

**PATENT ABSTRACTS OF JAPAN, vol. 9, no.
189, (E-333)[1912], 6th August 1985; & JP-
A-60 58 616**

**PATENT ABSTRACTS OF JAPAN, vol. 9, no.
318 (E-366)[2041], 13th December 1985; & JP-
A-60 152 023**

**JOURNAL OF THE ELECTROCHEMICAL SOCI-
ETY, vol. 130, no. 7, July 1983, pages
1571-1580, Manchester, New Hampshire, US;
L. JASTRZEBSKI et al.: "Growth process of
silicon over SiO2 by CVD: Epitaxial lateral
overgrowth technique"**

(73) Proprietor: **CANON KABUSHIKI KAISHA
30-2, 3-chome, Shimomaruko, Ohta-ku
Tokyo(JP)**

(72) Inventor: **Shirai, Shigeru
10-52, Shinzen-cho
Nagahama-shi Shiga-ken(JP)**

(74) Representative: **Beresford, Keith Denis Lewis
et al
BERESFORD & Co. 2-5 Warwick Court High
Holborn
London WC1R 5DJ (GB)**

Rank Xerox (UK) Business Services
(3.10/3.5x/3.0.1)

## Description

The present invention relates to a process suitable for formation of a functional deposited film containing silicon, especially a polycrystalline silicon-containing deposited film suitable for semiconductor devices, photosensitive devices for electrophotography, line sensors for inputting of images, image pick-up devices, etc.

For example, for formation of amorphous silicon films, there have been tried various processes such as vacuum evaporation process, plasma CVD process, CVD process, reactive sputtering process, ion plating process, photo CVD process, etc. and in general the plasma CVD process has been widely employed and commerciallized.

However, deposited films comprising amorphous silicon must be further improved in overall characteristics on electrical and optical characteristics, fatigue characteristics upon repeated uses, environmental characteristics, and productivity and mass-productivity including uniformity and reproducibility.

Especially, for some uses, electrical characteristics, enlargement of area, uniformity of film thickness and uniformity of film quality must be attained and mass-production with high reproducibility must also be practicable with high-speed film formation. For this purpose, a heavy equipment investment is required for apparatus for mass-production in formation of amorphous silicon deposited films by the plasma CVD process. Moreover, control items for the mass-production become complex to result in reduction of latitude for control and further, fine adjustment of apparatuses is necessary. Therefore, these points are further problems to be improved.

It is mentioned that in West German Patent Application No. DE-A-3429899 there is described a film deposition process in which previously activated species, one of which is produced by the decomposition of a compound containing both silicon and a halogen, are introduced into the film forming space of a chamber containing the substrate. This process is used to provide fine quality amorphous film on the active surface of the substrate.

On the other hand, normal pressure CVD or LPCVD process have been used for formation of polycrystalline deposited films of silicon, but these processes require high temperature and so substrate materials are limited. Besides, there are difficulties in control of crystal grain size, and of grain size distribution, compensation of defects present in grain boundaries or arrangement of crystal faces. For these reasons, there are also the problems that practicably sufficient characteristics cannot be obtained, enlargement of area is difficult, uniform film thickness and quality cannot be obtained, and reproducibility is poor.

In the plasma CVD process, temperature of substrate can be lowered as compared with the normal pressure CVD process or LPCVD process, but structure of reaction apparatuses is limited to form a stable plasma and further, there are many other parameters (kinds of introduction gases, flow rate of gas, pressure, radio frequency power, exhaust velocity, etc), which have considerabler effect on plasma stability. Therefore, plasma subtly varies due to a slight variation of these parameters and combination of them, often resulting in adverse effects on uniformity, and electrical and optical characteristics. Furthermore, bombardment of deposited films by electrons or ions present in plasma causes much damage. This is one of the factors causing deterioration in the film characteristics.

As explained above, at present, both the amorphous silicon film and polycrystalline silicon film have problems which are due to process of formation thereof. Especially, from the points of improvement and stabilization of electrical characteristics of deposited films, in formation of polycrystalline silicon films, development of a process for forming a polycrystalline silicon film of a large area at low cost with keeping practicably sufficient characteristics, uniformity, and stability has been demanded.

The photo-CVD process has been proposed for solving the above problems, but according to the conventional photo-CVD process, it is difficult to produce a polycrystal deposited film with controlling crystal grain size and grain sized distribution, electrical characteristics of grain boundaries are insufficient, and besides control of face direction is also difficult. Further, the photo-CVD process has limitation in usable raw material gases, and in general this process is not profitable in productivity and cost.

The process of the present invention is provided as an alternative to conventional normal pressure CVD and other conventional processes such as low pressure CVD, plasma CVD and photo-assisted CVD.

In accordance with the present invention there is provided a process for forming a silicon containing crystalline film, which process comprises:

providing in a deposition chamber a substrate a major surface of which is arranged to have spaced apart regions which either are each suited to support epitaxial growth of a silicon containing crystalline film, or each form silicon containing crystal nucleation surfaces;

introducing separately into said deposition chamber previously activated chemically mutually reactive first and second species and causing these to react and to deposit a silicon containing crystalline film upon

2

the surface of the substrate, said activated first species being formed by the decomposition of a compound containing both silicon and a halogen; and

exposing the deposited film growth surface to a gaseous etchant to effect crystal growth in a preferential face direction, whilst increasing etchant activity by irradiating this gaseous etchant with photo energy.

The process above is not restricted to small area deposition and large size areas can be deposited without substantial difficulty. The process above can also result in improvement in productivity and can be employed in mass production. It can also result in a substantial improvement in crystalline film characteristics, uniformity of film thickness and quality, forming rate etc., and is readily reproducible.

With reference to Art. 54(3)EPC a brief mention will be made of a number of published European Patent Applications as follows:-

EP-A-0241311 concerns the growth of crystalline film in circumstances where the substrate surface is sub-divided or otherwise treated to support initial growth or nucleation at a number of spaced apart locations. The provision of irradiation to enhance selective etchant activity is not disclosed.

EP-A-0241317 also concerns a process for growing a crystalline film in which etchant activity during growth is enhanced by UV-irradiation. It does not disclose the use of a substrate having a seeded surface or a surface having a number of dispersed nucleation sites. In the process described the deposited species is rearranged by heating.

EP-A-0242182 concerns the growth of a crystalline film upon a substrate the surface of which is crystalline and such therefore as to determine the orientation of material deposited upon it. Optionally in this process the etchant activity is photo-assisted.

EP-A-0242207 concerns a process in which the substrate surface is selectively treated by irradiation as a means of defining localised sites for initiating the growth or nucleation.

As the compound (SX) containing silicon and halogen which is introduced into the activation space (A), there may be used, for example, chain or cyclic silane compounds of which hydrogen atoms are all or partially substituted by halogen atoms. As examples of these compounds, mention may be made of chain silicon halides represented by the formula $Si_uY_{2u+2}$ (u is an integer of 1 or more and Y is at least one element selected from F, Cl, Br and I), cyclic silicon halides represented by the formula $Si_vY_{2v}$ (v is an integer of 3 or more and Y is the same as defined above), chain or cyclic compounds represented by the formula $Si_uH_xY_y$ (u and Y are the same as defined above and x + y = 2u or 2u + 2), etc.

Typical examples of these compounds are those which are gas or can easily be gasified such as $SiF_4$, $(SiF_2)_5$, $(SiF_2)_6$, $(SiF_2)_4$, $Si_2F_6$, $Si_3F_8$, $SiHF_3$, $SiH_2F_2$, $SiCl_4$, $(SiCl_2)_5$, $SiBr_4$, $(SiBr_2)_5$, $Si_2Cl_6$, $Si_2Br_6$, $SiHCl_3$, $SiH_3Cl$, $SiH_2Cl_2$, $SiHBr_3$, $SiHI_3$, $Si_2Cl_3F_3$, etc.

For formation of active species (A), if necessary, in combination with said compounds (SX) containing silicon and halogen there may be used single substance of silicon, other silicon compounds, hydrogen, halogen compounds (e.g., $F_2$ gas, $Cl_2$ gas, gasified $Br_2$, $I_2$, etc.), etc.

For production of active species (A) in the activation space (A) there may be used, considering the conditions and apparatuses, activation energies such as electric energies, e.g., microwave, RF, low frequency, DC, etc., heat energies such as heater heating, infrared heating, etc. and light energy.

The active species (A) is produced by applying activation energies such as heat, light, electricity or the like to the compounds referred to above in the activation space (A).

As the film-forming chemical substances (B) which produce active species (B) in the activation space (B) in this process hydrogen gas and/or halogen compounds (e.g., $F_2$ gas, $Cl_2$ gas, gasified $Br_2$, $I_2$, etc.) may be advantageously used. In addition to these film-forming chemical substances (B), for example, inert gases such as helium, argon, neon, etc. may also be used. When a plurality of these film-forming chemical substances (B) are used, these may be previously mixed and introduced in the form of gas into the activation space (B) or these substances in the form of gases may be separately supplied from separate supply sources and introduced into the activation space (B) or they may be separately introduced into separate activation spaces and separately activated.

Ratio of amount of the active species (A) and that of the active species (B) introduced into the film-forming space is suitably and desirably selected depending upon film-forming conditions, kind of the active species, etc. and preferably 10:1 - 1:10 (introduction flow rate ratio) and more preferably 8:2 - 4:6. In the present invention, as the active species (A) introduced into the film forming space generated from activation species (A), there may be appropriately selected and used those which have a life of preferably 0.1 second or more, more preferably 1 second or more and most preferably 10 seconds or more in view of productivity and easiness in handling. The constituting elements of this active species (A) constitute the ingredients of deposited film formed in the film-forming space. The film-forming chemical substance is activated by the action of activation energy in activation space (B) and is introduced into the film-forming space, where it interacts with active species (A) which is simultaneously introduced from activation space (A) and which contains the constituting element which becomes ingredient of the deposited film to be formed. As a result, a deposited film can be easily formed on the desired substrate.

During the film forming step, (a) etching action is applied to the growth surface of deposited film during film formation at the same time, or (b) etching action is applied to the growth surface of deposited film during interruption of the film formation, whereby crystal growth can be effected preferentially in a specific face direction to give a deposited film with good crystallinity. The etching action in the case of step (b) above may be effected within the film-forming space or alternatively in an etching space separate from the film forming space.

As the gaseous or readily gasifiable substance for etching (E) having etching action on the deposited film containing silicon, there may be included single substances of halogen, halide compounds or activated species (C) formed from these.

These substances (E) for etching may be introduced under gaseous state into the space where etching action is applied, or alternatively in the case when the substance (E) is formed by the surface reaction on the surface of the deposited film of the above activated species (A) or the above activated species (B), formed from the chemical reaction between the activated species (A) and the activated species (B), etching action is applied to the growth surface of the deposited film simultaneously with film formation.

For example, as an example in which the substance for etching is formed by the above surface reaction, the reaction between an activated species of halogen and hydrogen or a halogen and activated species of hydrogen occurs on the growth surface of the deposited film, and hydrogen halide (HX) is released from the growth surface of the deposited film and the hydrogen halide becomes the substance (E) for etching.

As gaseous substances (E) having etching action used in the present invention, mention may be made of halogens such as $F_2$, $Cl_2$, gasified $Br_2$, $I_2$, etc., halides such as carbon halides, e.g., $CHF_3$, $CF_4$, $C_2F_6$, $CCl_4$, $CBrF_3$, $CCl_2F_2$, $CCl_3F$, $CClF_3$, $C_2Cl_2F_4$, etc., boron halides, eg., $BCl_3$, $BF_3$, etc., halides such as $SF_6$ $NF_3$ $PF_5$ $XeF_2$, etc., radicals produced from these gases such as $F^*$, $Cl^*$, etc. and ions such as $CF_3^+$, $CCl_3^+$, etc. These may also be used in combination of two or more and further, gases such as $O_2$, $H_2$, and the like in an amount not to affect the film to control the etching characteristics.

The growth surface of deposited film is etched in the following manner with the gaseous substance (E). An etching space is arranged separately from the film-forming space, and the film formation and etching may be performed by alternately repeating. Alternatively, the gaseous substance (E) is introduced in a state of having etching activity and the etching action is carried out simultaneously or alternately with film formation to limit the crystal growth direction of the deposited film.

Furthermore, since the deposited film formed by the process of the present invention has sufficient semiconductor characteristics, the film may be subjected to doping with an impurity element during or after the film formation. As typical examples of the impurity elements used, mention may be made of elements of Group III A of the periodic table such as B, Al, Ga, In, Tl, etc. as p-type impurities, and those of Group V A of the periodic table such as P, As, Sb, Bi, etc. as n-type impurities. Especially preferred are B, Ga, P, and Sb. Amount of the impurities to be doped is suitably determined depending on the desired electrical and optical characteristics.

As substances (D) containing such impurity element as a component (substances for introduction of impurity), it is preferred to choose those compounds which are in a gaseous state at normal temperature and pressure or are gases at least under activation conditions and can be easily vaporised by a suitable vaporizer. As examples of such compounds, mention may be made of $PH_3$, $P_2H_4$, $PF_3$, $PF_5$, $PCl_3$, $AsH_3$, $AsF_3$, $AsF_5$, $AsCl_3$, $SbH_3$, $SbF_5$, $BiH_3$, $BF_3$, $BCl_3$, $BBr_3$, $B_2H_6$, $B_4H_{10}$, $B_5H_9$, $B_5H_{11}$, $B_6H_{10}$, $B_6H_{12}$, $AlCl_3$, etc. These compounds (D) containing impurity elements may be used alone or in combination of two or more.

The compound (D) containing impurity element as a component may be directly introduced, in a gaseous state, into the film forming space or may be previously activated in activation space (A) or (B) or a third activation space (C) and then introduced into the film-forming space.

On the other hand, the dependency of growth speed upon face direction has been found during crystal growth of silicon or silicon-containing materials. This may differ depending on the deposited film forming method or deposition conditions, but in the method of the present invention, the preferential order has been found to be (110) > (111) > (100). By suitable selection of the kind of substance (E) for etching and etching condition under this condition, the condition with stronger orientability of (110) ≫ (111) ≫ (100) can be realized. It is realized in the present invention to strengthen the above orientability and accelerate the growth speed, particularly by setting a portion for accelerating nucleation on the substrate. And, not only formation of polycrystalline deposited film with great grain size oriented only toward the (110) face is possible, but it is also possible to grow a single crystal by selecting the size, shape, interval, material, etc., of the nucleus.

In the present invention, the expression crystalline deposited film of course represents a polycrystalline and a single crystal film. The surface for promoting nucleation of the present invention may sometimes exists on the whole surface of the substrate, or sometimes as a part thereof, or otherwise many portions may be provided as separately dispersed. As the property demanded for the portion for promoting nucleation, it must be considered that the active species (A) in the vicinity of the substrate formed from compounds containing silicon and a halogen has a great coefficient of attachment. In order to enhance the coefficient of attachment, a material having a large coefficient of attachment may be employed or a surface structure for enhancing the coefficient of attachment may be formed. Coefficient of attachment generally refers to a quantity which is a measure for readiness in chemical adsorption to occur, and in the case of the present invention, physical adsorption and chemical adsorption including dissociation are also included. As the material enhancing the coefficient of attachment, those with surface unevenness of some 100 nm (1000 Å) or less are preferred. As to the shape, those with shapes as regular as possible rather than random are preferred.

The material having a large coefficient of attachment may be selected from among insulating substances and semiconductive substances such as Si : N : H, $Si_3N_4$, A-Si : H, Si : N : O : H, $Al_2O_3$, $SiO_2$, $Ta_2O_5$, etc., but particularly a compound containing Si-N is preferred. Also, a metal material may be sometimes employed. As mentioned above, the order of stronger orientability of crystal has been made as (110) > (111) > (100), but of course it is possible in the present invention to control the direction of oriented surface and the direction of the single crystal growth face depending on the conditions of deposition and nucleus.

The portion for promoting nucleation of the present invention do not have to be uniformly spread over the whole substrate surface, but a film with regular sized of crystal grains and crystal axis directions may be obtained by giving places where nuclei are liable to be generated locally. For selective formation of crystalline deposited film having desired face direction it is necessary that crystal nuclei of the deposited film be formed or regions which can selectively form crystal nuclei be previously and dispersively arranged on the surface of the substrate.

For example, a single crystal substrate partially covered with an amorphous thin film can be used as substrate or single crystal grains can be dispersively arranged on the substrate, so that crystal growth occurs either at exposed portions of the single crystal substrate or on the single crystal grains and thus epitaxial growth occurs selectively.

Specifically, for example, there may be used a silicon single crystal substrate partially covered with a silicon oxide film to selectively expose the underlying silicon single crystal surface or alternatively a substrate of silicon crystal small in growth property in which silicon single crystal grains are selectively arranged on the surface. Alternatively there may be used a crystal material different from silicon as nucleus in place of the silicon single crystal substrate or the silicon single crystalline grain, but such crystal materials must meet the following conditions:

1. The crystal lattice constant on the crystalline substrate surface is the same as or very close to that of the deposited film.

2. The coefficient of thermal expansion of the portion on the substrate surface is the same as or very close to that of the deposited film.

Taking the above conditions into consideration, specific materials to form the surface of the substrate for obtaining a deposited film of crystalline material Si to accomplish the objects of the present invention include $GaF_2$, ZnS, Yb, $Mn_3Ga$, $NaCoF_3$, $Ni_3Sn$, $Fe_3C$, $NiTe_x$ (x < 0.7), $CoMnO_3$, $NiMnO_3$, $MaZn_3$, CuCl, AIP, Si, etc. Even if the material does not meet the above two conditions in some degree, it is possible to obtain a silicon deposited film of the crystalline material by more suitably choosing the film forming conditions. Thus, this process is not limited to use of the above materials.

Also, for forming selectively a crystalline Si deposited film by selecting suitably the film-forming conditions and the kind of the substrate, there is a process in which the following kind of substrate is used. That is, it is the process for preparing a crystalline film by utilizing the difference in nucleation density according to the kind of the material constituting the nucleation surface for forming crystal nuclei, and the substrate used in said process has nucleation surfaces arranged scatteringly with a desired pattern on the non-nucleation surface. By use of such a substrate, a crystalline film can be selectively grown from said nucleation surfaces.

As such substrate, there may be specifically used, for example, an $SiO_2$ film on which $Si_3N_4$ is discretely arranged or an $Si_3N_4$ film which is covered with $SiO_2$ to partially expose the basic $Si_3N_4$ film.

5

This utilizes the properties of silicon crystal nuclei being produced with ease on $Si_3N_4$ surface and with difficulty on $SiO_2$ surface. In this process for formation of deposited film materials having differences in difficulty in formation of nuclei can be used regardless of the crystalline state of the surface which can then be either amorphous or crystalline.

In the present invention, when a gaseous substance (E) having etching action is permitted to exist in the film-forming space and the deposited film growth surface is exposed to said gaseous substance (E), etching action is promoted by irradiating said gaseous substance (E) with lightenergy. As the method for irradiation of light energy, there may be employed the method in which irradiation is effected toward the deposited film growth surface continuously or intermittently, whereby the irradiated light energy is permitted to act on the above gaseous substance (E) in the optical pathway of irradiation. As the light energy, energy of light having wavelength from far infrared so far ultraviolet can be used, including specifically strong luminosity light such as laser beam, halogen lamp rays, mercury lamp rays, etc. Irradiation of light energy can be effected during the whole time or during the partial time in the etching action step.

As mentioned above, the process can be made a more stable CVD process by optionally controlling the atmospheric temperature of the film-forming space and the substrate temperature.

One of the differences between the process of the present invention and the conventional CVD process is that the former uses active species which have previously been activated in a space (referred to as "activation space" hereinafter) different from the film-forming space.

Based on this flat, film forming speed can be markedly increased above that of the conventional CVD process and besides the substrate temperature at the time of forming the deposited film can be further lowered and thus it has become possible to provide deposited films of stable quality industrially in a large quantity and at low cost

The etching effect on said film-growing surface is aided by irradiation of light energy which provides etching selectivity. That is, a gaseous substance (E) having etching action is excited with light to increase etching activity and promote the crystal growth in a specific direction. This irradiation of light energy can be selected so that it can more efficiently act on the etching gas.

In the accompanying drawings:

Fig. 1 illustrates schematically the constitution of an example of the device for forming deposited film embodying the process of the present invention;

Fig.2 illustrates schematically a deposited film prepared according to the process of the present invention;

Fig. 3 is a partial perspective view illustrating schematically the constitution of the thin film transistor (TFT) prepared by use of the semiconductive deposited film prepared according to the process of the present invention;

Fig. 4 and Fig. 5 each illustrate schematically the steps for preparing the substrate to be used in the present invention.

Referring to the accompanying drawings, an example of the deposited film forming process of the present invention will be explained below with reference to deposition of a polycrystalline silicon film. The following description is given by way of example only:

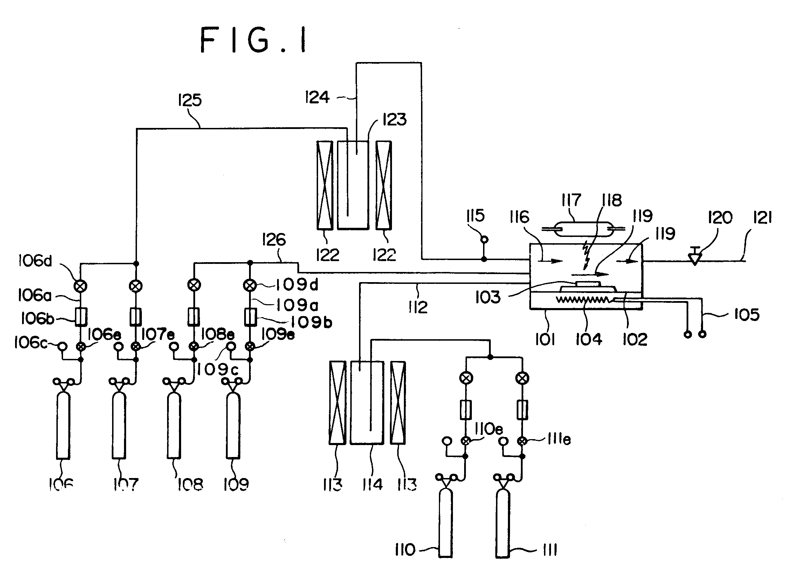

Fig. 1 is a schematic view which illustrates outline of one example of an apparatus for formation of a deposition film to perform the process of the present invention.

In Fig. 1, 101 indicates a deposition chamber where deposition of a polycrystalline silicon film is effected and the inside of the deposition chamber 101 is connected to an exhaust system (not shown) through an exhaust pipe 121, whereby the inside of deposition chamber 101 can be maintained at a desired pressure by an exhaust valve 120. The pressure in the deposition chamber 101 is adjusted to generally $10^{-3} - 10^2$ Pa $(10^{-5} - 1.0$ Torr) preferably $10^{-2} - 10$ Pa $(10^{-4}$ Torr - 0.1 Torr). In the deposition chamber 101, a desired substrate 103 is put on a substrate supporting stand 102.

104 indicates a heater for heating the substrate which is supplied with electricity through electric lead 105 to develop heat. The substrate temperature has no special limitation, but is preferably 100 - 500°C, and more preferably 150 - 400°C for performing this process.

106 - 111 indicate gas supply sources, which are provided depending on the number of silicon compound and hydrogen, halogen compound, inert gas and compound containing impurity element which are used, as necessary. If a liquid raw material compound is used, an optional vaporizer is also provided. 106a - 111a indicate branch pipes, 106b - 111b indicate flowmeters, 106c - 111c indicate pressure gases for measurement of pressure at higher pressure side of each flowmeter, and 106d - 111d and 106e - 111e indicate valves for adjustment of respective gas flow rate. 112, 125 and 126 indicate pipes for introduction of gas into film forming space.

6

117 indicates a light energy-generating device such as mercury lamp, xenon lamp, carbon dioxide laser, argon ion laser, excimer laser.

Light 118 directed to the whole substrate or desired part of the substrate from the light energy-generating device 17 by a suitable optical system is irradiated to a gaseous substance (E) having etching action flowing in the direction of arrow 119.

114 and 123 indicate activation spaces for producing active species (A) and active species (B), respectively and 113 and 122 indicate devices for generation of microwave plasma for production of the active species.

The following examples further illustrate this invention.

Example 1

Using the apparatus of Fig. 1, a deposited film was formed according to the process of the present invention in the following manner.

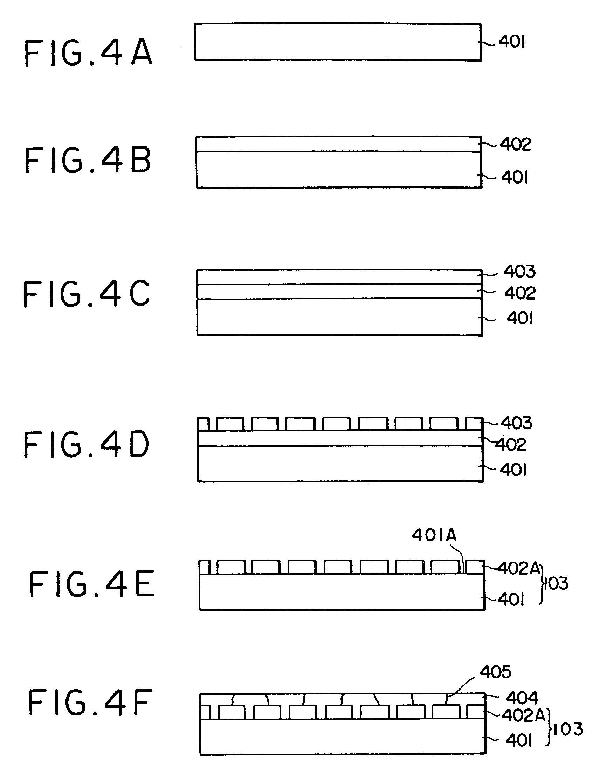

Substrate 103 was produced by the steps as shown in Fig. 4.

First, polycrystalline silicon substrate 401 as shown by (A) in Fig. 4 was cleaned, followed by depositing a silicon oxide thin film 402 on the whole surface of the substrate by the sputtering process (various thin film deposition process other than the sputtering process, e.g. the vacuum evaporation process, sputtering process, plasma discharge process, MBE process, CVD process, etc. can be employed.) [ (B) in Fig. 4 ].

Then, on the thin film 402 was coated by an electron radiation resist 403 [ (C) in Fig. 4 ], which was then selectively exposed using a photo mask having desired pattern and developed to partially remove the resist 403 [ (D) in Fig. 4 ].

Silicon oxide thin film 402 was selectively etched using the remaining electron radiation resist 403 as a mask to form the thin film 402A of desired pattern [ (E) in Fig. 4 ].

Through the above steps, there was obtained a silicon substrate 103 having a portion 401 in which the polycrystalline silicon is exposed at constant intervals from thin films 402A. The exposed parts 401A of the silicon crystal have a diameter of several tens nm (several hundred Å) and are at intervals of 5 $\mu$m.

Then, the deposition chamber 101 was subjected to internal evacuation by an evacuation device (not shown) to reduce the inner pressure to about $10^{-4}$ Pa ($10^{-6}$ Torr). 50 sccm of $H_2$ gas was introduced into an activation chamber (B) 123 through a gas introduction pipe 125 from a gas supply bomb. The $H_2$ gas, etc. introduced into the activation chamber (B) 123 were converted by a microwave plasma generating device 122 to active specias (B) such as hydrogen, etc., which were introduced into the film forming chamber 101 through an introduction pipe 124.

Into an activation chamber (A) 114 was introduced 20 sccm of $SiF_4$ gas through a gas introduction pipe 112. The $SiF_4$ gas introduced into the activation chamber (A) 114 was converted by the activation with microwave plasma generating device 113 to active species (A) such as $SiF_2$, etc. and introduced into a film-forming chamber 101 through an introduction pipe 112.

Furthermore, 10 sccm of $F_2$ gas as an etching gas was introduced into the film-forming chamber 101 through a gas introduction pipe 126.

With keeping the inner pressure of film forming chamber 101 at 2 Pa (0.02 Torr), light from 1 KW Xe lamp was vertically irradiated onto the substrate 103 previously heated to 350°C by the heater 104 to react the active species with each other, thereby to form a polycrystalline silicon film and simultaneously, $F_2$ gas was activated by said irradiation with light to produce F* fluorine free radical and polycrystalline silicon film strong in certain orientation was formed by etching said polycrystalline film as deposited utilizing difference in etching speed of said fluorine free radical depending on crystal faces. In this case, difference in etching speed depending on crystal faces is (1, 0, 0) > (1, 1, 1) > (1, 1, 0) and a polycrystalline silicon film having (1, 1, 0) as a main crystal face was formed on substrate. This fact was confirmed in the following manner. According to evaluation by X-ray diffraction of this sample, peak intensity at crystal angle (2∅) = 47.3° which reflected the (1, 1, 0) face was 7 - 10 times those at crystal angle (2∅) = 28.4° and 69.2° which reflected the (1, 1, 1) face and (1, 0, 0) face, respectively.

The cross section of thus obtained silicon deposited film on the substrate 103 was diagrammatically shown in (F) of Fig. 4.

Each deposited film sample was evaluated by X-ray diffractometry and electron diffractometry to find that they were polycrystalline silicon films. Size of crystal grains 404 was determined so that grain boundaries 405 are in equal distance from exposed parts 401A of the crystal substrate 401 from which the silicon oxide layer 402A was removed. Observation by a transmission type electron microscope revealed that grain diameter of the polycrystalline silicon was about 5±0.2 $\mu$m. There were substantially no scatters of grain diameter on over-all surface of the substrate.

According to observation of surface state of the samples by a scanning type electron microscope, they had good smoothness, no ripples and film thickness unevenness t is ±4% or less.

Then, the thus obtained polycrystalline silicon film samples were put in a vacuum evaporation tank, where comb-shaped Al gap electrode (length 250 $\mu$m, 5 mm) was made under a degree of vacuum of $10^{-3}$ Pa ($10^{-5}$)Torr) and then dark current was measured at applied voltage 10V and dark current $\sigma d$ was obtained, thereby to evaluate the polycrystalline silicon film.

The above mentioned film forming conditions and results of evaluation of the deposited films are shown in Tables 1 and 2, respectively.

Table 1

| | Gas | Flow rate (SCCM) | Discharge power (W) | Substrate temperature (°C) | Inner pressure (Torr) Pa | Light source | Film forming speed (Å/s) nm/s |
|---|---|---|---|---|---|---|---|
| Activation space (A) | $SiF_4$ | 20 | 500 | 350 | 2 ( 0.02 ) | Xe lamp 1Kw | 0.2 (2) |
| Activation space (B) | $H_2$ | 50 | 200 | | | | |
| Etching conditions | $F_2$ | 10 | | | | | |

Table 2

| Sample No. | $\sigma d$ ($\Omega$ cm$^{-1}$) | X-ray diffraction | | Grain size ($\mu$m) | H content ( atomic % ) |
|---|---|---|---|---|---|
| | | (2,2,0)/(1,1,1) | (1,1,0)/(4,0,0) | | |
| 1 | $8.1 \times 10^{-4}$ | 7/1 | 10/1 | 5.0 | 0.05 |

* In table 2, 3, 4, 5, 7, 9 and 11, (2, 2, 0)/(1, 1, 1) and (2, 0, 0) / (4, 0, 0) are ratio of peak intensity reflecting $I/I_o$ of each crystal face and ASTM card.

9

Example 2

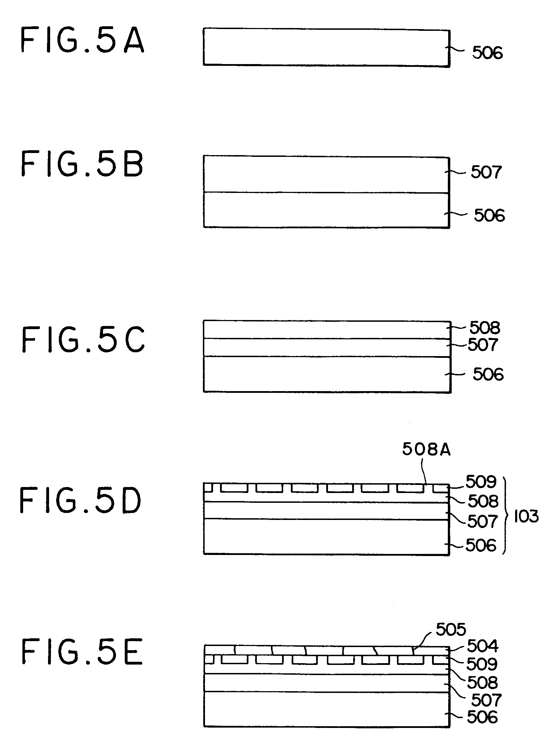

Substrate 103 was produced by the steps shown in Fig. 5.

Substrate 506 comprising a homogeneous material as shown in (A) of Fig. 5 was cleaned and subsequently, (amorphous SiN referred to as A-SiN) thin film 507 was formed at a thickness of about 2 $\mu$m on the whole surface of substrate 506 by CVD process [ (B) in Fig. 5 ].

Then, the surface of the A-SiN thin film 507 was subjected to surface annealing in $N_2$ atmosphere by a laser annealing apparatus to form crystalline substance $Si_3N_4$ (referred to as $C-Si_3N_4$) 508 to the depth of 1 $\mu$m of the surface layer of A-SiN thin film 507 [ (C) in Fig. 5 ].

In this case, laser of ArF laser 193 nm, pulse width 50 nsec, and average power density 100 mJ/cm$^2$ was used and irradiation was carried out at 40 /s. Then, the surface of this $C-Si_3N_4$ 508 was subjected to scanning by said laser annealing apparatus in $O_2$ atmosphere to selectively form $SiO_2$ region 509 [ (D) in Fig. 5 ].

By the above steps, there was formed substrate 103 where $C-Si_3N_4$ regions 508A were exposed at constant intervals from the $SiO_2$ region 509 and other parts were covered with $SiO_2$ 509. The exposed $C-Si_3N_4$ regions 508A on the substrate surface had a diameter of about 0.4 nm (4 Å) and were at intervals of 3 $\mu$m.

Deposition of crystalline silicon was further carried out using this substrate 103 under the same conditions as used in Example 1 and by the apparatus shown in Fig. 1.

Section of the crystalline silicon deposited film formed on this substrate 103 is diagrammatically shown in (E) of Fig. 5.

The thus obtained smaples were subjected to evaluation of crystalline property by X-ray diffractometry and electron diffractometry to find that they were polycrystalline silicon films. Size of crystal grains 504 was determined so that grain boundaries 505 were in equal distance from the $C-Si_3N_4$ regions 508A. Grain diameter of the polycrystalline silicon was about 3 ± 0.5 $\mu$m. A few scatters of grain diameter were seen over-all surface of the substrate.

The surface state was observed by a scanning type electron microscope to find that the surface had good smoothness, no ripples and film thickness unevenness t was ± 4% or less.

Table 3

| Sample No. | $\sigma_d$ ($\mho\,cm^{-1}$) | X-ray diffraction | | Grain size ($\mu m$) | H content (atomic%) |
|---|---|---|---|---|---|
| | | $(2,2,0)/(1,1,1)$ | $(2,2,0)/(4,0,0)$ | | |
| 2 | $9.1 \times 10^{-5}$ | 7/1 | 10/1 | 3.0 | 0.07 |

Example 3

Films were formed under the same conditions as in Example 2 except that kind and flow rate of gases were changed as shown in Table 4. The results of evaluations are shown in Table 5.

Table 4

| Sample No. | | 3-1 | 3-2 | 3-3 | 3-4 | 3-5 | | 3-6 |
|---|---|---|---|---|---|---|---|---|
| Activation space (A) | Gas flow rate (SCCM) | $Si_2F_6$ 10 | $SiH_2F_2$ 20 | $SiCl_4$ 20 | $SiH_2Cl_2$ 20 | $SiF_4$ 20 | Ar 50 | $SiF_4$ 20 |
| Activation space (B) | Gas flow rate (SCCM) | $H_2$ 50 | $H_2$ 30 | $H_2$ 50 | $H_2$ 30 | $H_2$ 50 | Ar 50 | $H_2$ 50 |
| Etching gas | Gas flow rate (SCCM) | $F_2$ 10 | $F_2$ 10 | $F_2$ 10 | $F_2$ 10 | $F_2$ 10 | | $Cl_2$ 10 |

EP 0 243 074 B1

Table 5

| Sample No. | $\sigma_d$ ($\Omega\,cm^{-1}$) | X-ray diffraction | | Grain size (μm) | H content (atomic %) |
|---|---|---|---|---|---|
| | | (2,2,0) / (1,1,1,) | (2,2,0) / (4,0,0) | | |
| 3-1 | $7.0 \times 10^{-5}$ | 6/1 | 8/1 | 2.8 | 0.05 |
| 3-2 | $3.1 \times 10^{-4}$ | 12/1 | 20/1 | 3.2 | 0.03 |
| 3-3 | $9.0 \times 10^{-5}$ | 8/1 | 12/1 | 3.5 | 0.02 |
| 3-4 | $2.0 \times 10^{-4}$ | 10/1 | 14/1 | 3.0 | 0.03 |
| 3-5 | $1.0 \times 10^{-4}$ | 8/1 | 11/1 | 3.1 | 0.01 |
| 3-6 | $1.4 \times 10^{-4}$ | 8/1 | 12/1 | 3.1 | 0.02 |

Example 4

Films were formed under the same conditions as in Example 1 except that a doping gas was introduced into the activation space (A) under the conditions as shown in Table 6.

Results of evaluation are shown in Table 7.

Table 6

| Activation space (A) | Sample No. | 4-1 | 4-2 | 4-3 | 4-4 |
|---|---|---|---|---|---|
| | Gas flow rate (SCCM) | SiF$_4$ 20 | SiF$_4$ 20 | SiF$_4$ 20 | SiF$_4$ 20 |
| | Doping gas concentration (ppm) | BF$_3$ 100 | BF$_3$ 500 | BF$_5$ 100 | BF$_5$ 500 |

* Concentration is a ratio of flow rates of doping gas and raw-material gas (SiF$_4$ gas) and doping gas is hydrogen diluted to 3000 ppm.

Table 7

| Sample No | $\sigma_d$ ($℧\,cm^{-1}$) | X-ray diffraction | | Grain size ($\mu m$) | H content (atomic %) |
|---|---|---|---|---|---|
| | | $(2,2,0)/(1,1,1,)$ | $(2,2,0)/(4,0,0)$ | | |
| 4-1 | $2.0 \times 10^{-2}$ | 7/1 | 10/1 | 5.2 | 0.02 |
| 4-2 | $8.0 \times 10^{-2}$ | 8/1 | 12/1 | 5.3 | 0.03 |
| 4-3 | $1.3 \times 10^{-2}$ | 7/1 | 10/1 | 5.2 | 0.02 |
| 4-4 | $7.0 \times 10^{-2}$ | 8/1 | 12/1 | 5.4 | 0.03 |

Example 5

Films were formed under the same conditions as in Example 2 except that a halogen-containing gas was introduced into the film forming space under the conditions as shown in Table 8.

Results of evaluation are shown in Table 9.

Table 8

| Sample No. | 5 - 1 | 5 - 2 | 5 - 3 | 5 - 4 | 5 - 5 |
|---|---|---|---|---|---|
| Gas | $F_2$ | $F_2$ | $F_2$ | $F_2$ | $F_2$ |
| Flow rate | 0 | 5 | 10 | 50 | 100 |

Table 9

| Sample No. | σd ($\Omega$cm$^{-1}$) | X-ray diffraction | | Grain size ($\mu$m) | H content (atomic) % |
|---|---|---|---|---|---|
| | | (2,2,0)/(1,1,1) | (2,2,0)/(4,0,0) | | |
| 5 - 1 | $4.0 \times 10^{-5}$ | 2/1 | 3/1 | 2.3 | 0.06 |
| 5 - 2 | $7.0 \times 10^{-5}$ | 4/1 | 6/1 | 2.5 | 0.04 |
| 5 - 3 | $9.0 \times 10^{-5}$ | 6/1 | 8/1 | 2.9 | 0.03 |
| 5 - 4 | $1.3 \times 10^{-4}$ | 10/1 | 15/1 | 3.5 | * |
| 5 - 5 ** | — | — | — | — | — |

* H was not detected.

** In the case of sample 4 - 5, no film was formed and Si wafer for IR analysis was etched.

Example 6

Films were formed under the same conditions as in Example 2 except that the discharge power in the activation space (A) and activation space (B) was changed as shown in Table 10.

17

Results of evaluation are shown in Table 11.

Table 10

| Sample No. | 6-1 | 6-2 | 6-3 | 6-4 | 6-5 | 6-6 | 6-7 | 6-8 |
|---|---|---|---|---|---|---|---|---|
| Discharge power in (A) (W) | 100 | 300 | 700 | 1000 | 500 | 500 | 500 | 500 |
| Discharge power in (B) (W) | 200 | 200 | 200 | 200 | 50 | 100 | 300 | 500 |

Table 11

| Sample No. | σ d ($\mho$ cm$^{-1}$) | X-ray diffraction | | Grain size (μm) | H content (atomic) % |
|---|---|---|---|---|---|
| | | (2,2,0)/(1,1,1) | (2,2,0)/(4,0,0) | | |
| 6 - 1 | $3.0 \times 10^{-5}$ | 4/1 | 5/1 | 2.7 | 0.06 |
| 6 - 2 | $7.0 \times 10^{-5}$ | 5/1 | 8/1 | 2.8 | 0.04 |
| 6 - 3 | $2.0 \times 10^{-4}$ | 9/1 | 13/1 | 3.2 | 0.01 |
| 6 - 4 | $9.0 \times 10^{-5}$ | 7/1 | 10/1 | 3.2 | *___ |
| 6 - 5 | $5.0 \times 10^{-5}$ | 5/1 | 7/1 | 2.8 | *___ |
| 6 - 6 | $9.0 \times 10^{-5}$ | 6/1 | 9/1 | 3.0 | 0.01 |
| 6 - 7 | $1.2 \times 10^{-4}$ | 7/1 | 10/1 | 3.2 | 0.03 |
| 6 - 8 . | $9.0 \times 10^{-5}$ | 7/1 | 10/1 | 3.1 | 0.04 |

* H was not detected.

EP 0 243 074 B1

Table 12

| Sample No. | 7 - 1 | 7 - 2 | 7 - 3 | 7 - 4 | 7 - 5 |
|---|---|---|---|---|---|
| Substrate temperature (°C) | 50 | 150 | 250 | 450 | 650 |

Example 7

Films were formed under the same conditions as in Example 12 except that the substrate temperature was changed as indicated in Table 12. Results of evaluation are shown in Table 13.

20

Table 13

| Sample No. | $\sigma d$ ($\Omega \cdot cm^{-1}$) | X-ray diffraction | | Grain size ($\mu m$) | H content (atomic)% |
|---|---|---|---|---|---|
| | | (2,2,0)/(1,1,1) | (2,2,0)/(4,0,0) | | |
| 7 - 1 | $2.1 \times 10^{-6}$ | 1/1 | 2/1 | 1.1 | 1.0 |
| 7 - 2 | $9.0 \times 10^{-6}$ | 2/1 | 4/1 | 1.5 | 0.6 |
| 7 - 3 | $5.0 \times 10^{-5}$ | 4/1 | 7/1 | 2.0 | 0.2 |
| 7 - 4 | $1.0 \times 10^{-4}$ | 10/1 | 12/1 | 3.4 | 0.05 |
| 7 - 5 | $8.0 \times 10^{-5}$ | 12/1 | 15/1 | 3.5 | * |

* H was not detected.

## Example 8

Films were formed under the same conditions as in Example 2 except that the inner pressure was changed as shown in Table 14. Results of evaluation are shown in Table 15.

Table 14

| Sample No. | 8 - 1 | 8 - 2 | 8 - 3 | 8 - 4 | 8 - 5 |
|---|---|---|---|---|---|
| Inner pressure (Torr) | 0.0001 | 0.001 | 0.01 | 0.1 | 1.0 |

Table 15

| Sample No. | σd (Ω⁻¹cm⁻¹) | X-ray diffraction | | Grain size (μm) | H content (atomic)% |
|---|---|---|---|---|---|
| | | $(2,2,0)/(1,1,1)$ | $(2,2,0)/(4,0,0)$ | | |
| 8 - 1 | $3.0 \times 10^{-4}$ | 8/1 | 15/1 | 3.3 | 0.02 |
| 8 - 2 | $2.0 \times 10^{-4}$ | 7/1 | 13/1 | 3.2 | 0.04 |
| 8 - 3 | $1.5 \times 10^{-4}$ | 7/1 | 10/1 | 3.2 | 0.05 |
| 8 - 4 | $8.0 \times 10^{-5}$ | 6/1 | 8/1 | 2.8 | 0.08 |
| 8 - 5 | $4.0 \times 10^{-5}$ | 5/1 | 7/1 | 2.5 | 0.1 |

Example 9

Films were formed under the same conditions as in Example 2 except that the power output of light source was changed as shown in Table 16. Results of evaluation are shown in Table 17.

Table 16

| Sample No. | 9 - 1 | 9 - 2 | 9 - 3 | 9 - 4 |
|---|---|---|---|---|
| Output of Xe lamp (W) | 0.1 | 0.5 | 2.0 | 3.0 |

Table 17

| Sample No. | $\sigma d$ ($\Omega^{-1}cm^{-1}$) | X-ray diffraction (2,2,0)/(1,1,1) | X-ray diffraction (2,2,0)/(4,0,0) | Grain size (μm) | H content (atomic) % |
|---|---|---|---|---|---|
| 9 - 1 | $4.0 \times 10^{-5}$ | 5/1 | 7/1 | 2.4 | 0.8 |
| 9 - 2 | $7.0 \times 10^{-5}$ | 6/1 | 8/1 | 2.6 | 0.6 |
| 9 - 3 | $1.0 \times 10^{-4}$ | 8/1 | 12/1 | 3.5 | 0.04 |
| 9 - 4 | $1.1 \times 10^{-4}$ | 10/1 | 12/1 | 3.5 | 0.01 |

Example 10

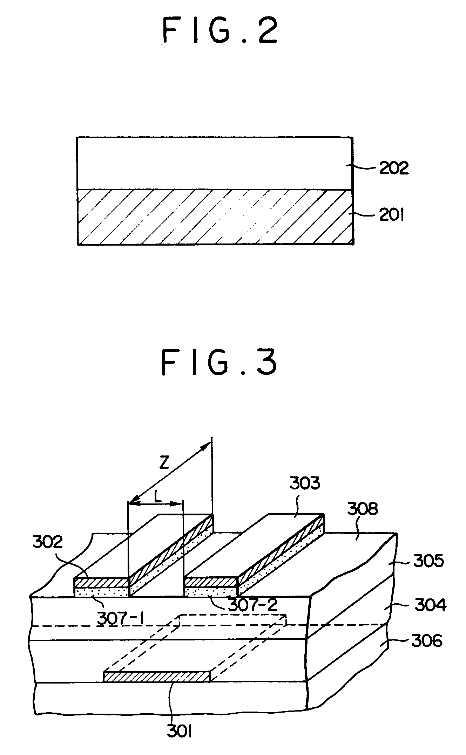

Fig. 3 is an oblique partial view which diagrammatically shows the structure of a thin film transistor (referred to as "TFT" hereinafter) of which semiconductor sections were constructed of polycrystalline silicon formed by this Example. The polycrystalline silicon TFT shown in Fig. 3 was formed by consecutive lamination of a gate electrode 301, an electrically insulating layer 304 covering said gate electrode 301, and a semiconductor layer 305 comprising polycrystalline silicon on a substrate 306 of glass, ceramics, etc. On the surface 308 of semiconductor layer 305 were juxtaposed a first $n^+$ layer 307-1 and a second $n^+$ layer 307-2 at an interval and further, on the first $n^+$ layer 307-1 was provided source electrode 302 and on the second $n^+$ layer 307-2 was drain electrode 303.

The first $n^+$ layer 307-1 and the second $n^+$ layer 307-2 provided on the surface (green surface) 308 of semiconductor layer 305 in contact with the surface were formed without exposing the surface 308 to atmosphere or oxygen after the semiconductor layer 305 was formed. The distance L between the source electrode 302 and drain electrode 303 was 50 $\mu$m and the length Z of them was 10 mm. The polycrystalline silicon film 305 was prepared in the following manner. Firstly, an insulating layer 304 provided on the substrate 306 was formed by similar steps to those in Example 2. That is, the gate electrode 301 was previously provided on the substrate 306 and then an A-SiN thin film was formed at about 2 $\mu$m thick on the whole surface of substrate 306 by CVD process. Subsequently, the A-SiN thin film was subjected to surface annealing in $N_2$ atmosphere by a laser annealing apparatus to form $C$-$Si_3N_4$ layer to the depth of 1 $\mu$m in the surface layer of A-SiN thin film. Subsequently, the surface of this $C$-$Si_3N_4$ layer was subjected to scanning by said laser annealing apparatus in $O_2$ atmosphere to selectively form $SiO_2$ regions. Through these steps, there was formed a substrate where $C$-$Si_3N_4$ was exposed at constant intervals and other part was covered with $SiO_2$ region. The regions of the exposed $C$-$Si_3N_4$ on the substrate surface had a diameter of about 4 Å and were arranged at an interval of 3 $\mu$m.

The semiconductor layer 305 in this Example was formed under the same conditions as for sample No. 2, 3-2 shown in Tables 3 and 5.

The above TFT samples (Nos. 10-1 and 10-2) were prepared by using the above semiconductor deposited films. For these TFT samples, characteristics when the drain electrode was grounded and ⊕ voltages were applied to the source electrode and the gate electrode with variation were measured.

With reference to drain current $I_D$-drain voltage $V_D$ characteristics, saturated characteristics were obtained for both Nos. 10-1 and 10-2 and a high current of 5 x $10^{-3}$ A was obtained at gate voltage 10V and drain voltage 10V. TFT characteristics obtained from the results by measuring drain current $I_D$ with changing gate voltage $V_G$ are shown in Table 18.

From the above results, it was recognized that TFT using the obtained polycrystalline silicon exhibited good characteristics.

Table 18

| Sample No. | 10-1 | 10-2 |
|---|---|---|
| Ratio of maximum value and minimum value of drain current* | 5 x $10^6$ | 8 x $10^6$ |
| Mobility of electric field effect ($cm^2$/v•sec)** | 250 | 300 |
| Threshold voltage | 1.0 | 0.8 |

*: Measured with changing gate voltage (Drain voltage $V_D$ = 10V constant)
**: Calculated from $\sqrt{ID}$ - V dependency.

The semiconductor layer of same No. 10-1 was formed under the same film forming conditions as for No.2, and that of sample No. 10-2 was formed under the same conditions as for sample No. 3-2.

**Claims**

1. A process for forming a silicon containing crystalline film, which process comprises:

providing in a deposition chamber a substrate a major surface of which is arranged to have spaced apart regions which either are each suited to support epitaxial growth of a silicon containing crystalline film, or each form silicon containing crystal nucleation surfaces;

introducing separately into said deposition chamber previously activated chemically mutually reactive first and second species and causing these to react and to deposit a silicon containing crystalline film upon the surface of the substrate, said activated first species being formed by the decomposition of a compound containing both silicon and a halogen; and

exposing the deposited film growth surface to a gaseous etchant to effect crystal growth in a preferential face direction, whilst increasing etchant activity by irradiating this gaseous etchant with photo energy.

**2.** A process as claimed in claim 1 wherein said activated first species is formed by the decomposition of a chain halogenated silane represented by $Si_uY_{2u+2}$, wherein $u$ is an integer of 1 or more and Y is at least one element selected from F, Cl, Br or I.

**3.** A process as claimed in claim 1 wherein said activated first species is formed by the decomposition of a chain or cyclic halogenated silane represented by the formula $Si_uH_xY_y$, wherein $u$ , $x$ and $y$ are integers of 1 or more, x + y = 2u or x + y = 2u + 2, and Y is at least one element selected from F, Cl, Br or I.

**4.** A process as claimed in claim 1 wherein either hydrogen or a halogen is used in addition to said compound during the decomposition thereof.

**5.** A process as claimed in claim 1 wherein said activated second species is formed from either hydrogen gas or a halogen gas.

**6.** A process as claimed in claim 1 wherein said activated first and second activated species are introduced into the film forming space at flow rates in a ratio of between 10:1 and 1:10.

**7.** A process according to claim 1 wherein said activated first species is formed by the decomposition of said compound containing silicon and a halogen in the presence of a compound containing an element for doping the film.

**8.** A process as claimed in claim 1 wherein a compound containing an element for doping the film is present with another chemical substance during formation of said activatedd second species.

**9.** A process as claimed in claim 1 wherein an activated species that is formed from a compound containing an element for doping the film is also introduced into said film forming space during film deposition.

**Patentansprüche**

**1.** Verfahren zur Herstellung eines siliziumhaltigen kristallinen Films, welches folgende Schritte umfaßt:

Bereitstellung eines Schichtträgers in einer Abscheidungskammer, wobei eine seiner Hauptoberflächen so angeordnet ist, daß sie auseinander gelegene Bereiche aufweist, die entweder jeweils dazu geeignet sind, epitaktisches Wachstum eines siliziumhaltigen kristallinen Films zu unterstützen, oder jeweils siliziumhaltige Oberflächen zur Kristallkeimbildung bilden,

getrennte Einleitung von zuvor aktivierten, chemisch miteinander reaktiven ersten und zweiten Spezies in die Abscheidungskammer und Veranlassung ihrer Umsetzung und Abscheidung eines siliziumhaltigen kristallinen Films auf der Oberfläche des Schichtträgers, wobei die aktivierte erste Spezies aus der Zersetzung einer Verbindung, die sowohl Silizium als auch ein Halogen enthält, gebildet wird; und

Aussetzen der Wachstumsoberfläche des abgeschiedenen Films einem gasförmigen Ätzmittel unter Erzielung eines Kristallwachstum in einer bevorzugten Kristallflächenrichtung unter gleichzeitiger Erhöhung der Ätzwirkung durch Bestrahlen des gasförmigen Ätzmittels mit Photoenergie.

**2.** Verfahren nach Anspruch 1, wobei die aktivierte erste Spezies durch die Zersetzung eines halogenierten Kettensilans gebildet wird, dargestellt durch $Si_uY_{2u+2}$, wobei $u$ eine Ganzzahl von 1 oder mehr ist, und Y mindestens ein aus F, Cl, Br oder I ausgewähltes Element ist.

**3.** Verfahren nach Anspruch 1, wobei die aktivierte erste Spezies durch die Zersetzung eines halogenierten Kettensilans oder cyclischen Silans gebildet wird, dargestellt durch die Formel $Si_uH_xY_y$, wobei u, x, und y Ganzzahlen von 1 oder mehr sind, x + Y = 2u oder x + Y = 2u + 2 ist, und Y mindestens ein aus F, Cl, Br oder I ausgewähltes Element ist.

**4.** Verfahren nach Anspruch 1, wobei entweder Wasserstoff oder Halogen, zusätzlich zu besagter Verbindung während ihrer Zersetzung, verwendet wird.

27

**5.** Verfahren nach Anspruch 1, wobei die aktivierte zweite Spezies entweder aus Wasserstoffgas oder aus Halogengas gebildet wird.

**6.** Verfahren nach Anspruch 1, wobei die aktivierte erste und die aktivierte zweite Spezies in den Filmbildungsraum mit Strömungsgeschwindigkeiten im Verhältnis zwischen 10:1 und 1:10 eingeleitet werden.

**7.** Verfahren nach Anspruch 1, wobei die aktivierte erste Spezies durch die Zersetzung der Verbindung, die Silizium und ein Halogen enthält, in Anwesenheit einer Verbindung, die ein Element für eine Dotierung des Films enthält, gebildet wird.

**8.** Verfahren nach Anspruch 1, wobei eine Verbindung, die ein Element für eine Dotierung des Films enthält, mit einer anderen chemischen Substanz während der Bildung der aktivierten zweiten Spezies vorhanden ist.

**9.** Verfahren nach Anspruch 1, wobei eine aktivierte Spezies, gebildet aus einer Verbindung, die ein Element für eine Dotierung des Films enthält, ebenfalls in den Filmbildungsraum während der Abscheidung des Films eingeleitet wird.

**Revendications**

**1.** Procédé de formation d'un film cristallin contenant du silicium, qui consiste :
à placer dans une chambre de déposition un substrat dont une surface principale est disposée de manière à comprendre des régions espacées qui conviennent chacune pour provoquer la croissance épitaxiale d'un film cristallin contenant du silicium, ou qui forment chacune des surfaces de nucléation de cristaux contenant du silicium ;
à introduire séparément dans ladite chambre de déposition des première et seconde entités préalablement activées, mutuellement réactives chimiquement, et à provoquer la réaction de ces entités et le dépôt d'un film cristallin contenant du silicium sur la surface du substrat, ladite première entité activée étant formée par décomposition d'un composé contenant à la fois du silicium et un halogène ; et
à exposer la surface de croissance du film déposé à un agent gazeux d'attaque chimique pour provoquer la croissance cristalline dans une direction de face préférentielle, tout en accroissant simultanément l'activité de l'agent d'attaque chimique par irradiation de cet agent gazeux d'attaque chimique avec de l'énergie lumineuse.

**2.** Procédé suivant la revendication 1, dans lequel la première entité activée est formée par décomposition d'un silane halogéné à molécule en chaîne représenté par la formule $Si_u Y_{2u+2}$, dans laquelle $u$ représente un nombre entier égal ou supérieur à 1 et Y représente au moins un élément choisi entre $\bar{F}$, Cl, Br et I.

**3.** Procédé suivant la revendication 1, dans lequel la première entité activée est formée par décomposition d'un silane halogéné à molécule en chaîne ou cyclique représenté par la formule $Si_u H_x Y_y$, dans laquelle u, x et y représentent des nombres entiers égaux ou supérieurs à 1, la somme $x + y$ est égale à $2u$ ou la somme $x + y$ est égale à $2u + 2$, et Y représente au moins un élément choisi entre F, Cl, Br et I.

**4.** Procédé suivant la revendication 1, dans lequel l'hydrogène ou un halogène est utilisé en plus du composé au cours de la décomposition de ce composé.

**5.** Procédé suivant la revendication 1, dans lequel la seconde entité activée est formée à partir d'hydrogène gazeux ou d'un halogène gazeux.

**6.** Procédé suivant la revendication 1, dans lequel les première et seconde entités activées sont introduites dans l'espace de formation de film à un rapport des débits compris dans l'intervalle de 10:1 à 1:10.

**7.** Procédé suivant la revendication 1, dans lequel la première entité activée est formée par décomposition du composé contenant du silicium et un halogène en présence d'un composé contenant un élément destiné au dopage du film.

8.  Procédé suivant la revendication 1, dans lequel un composé contenant un élément pour le dopage du film est présent avec une autre substance chimique au cours de la formation de la seconde entité activée.

9.  Procédé suivant la revendication 1, dans lequel une entité activée qui est formée à partir d'un composé contenant un élément pour le dopage du film est également introduite dans l'espace de formation de film au cours de la déposition du film.

FIG.1

# FIG. 2

# FIG. 3

FIG.4A

FIG.4B

FIG.4C

FIG.4D

FIG.4E

FIG.4F

FIG.5A

FIG.5B

FIG.5C

FIG.5D

FIG.5E